# FASCICULE DE BREVET EUROPEEN

(11) **EP 2 744 311 B1**
(45) Date de publication et mention de la délivrance du brevet: **20.01.2021**
(21) Numéro de dépôt: 13196272.2
(22) Date de dépôt: 09.12.2013
(51) Int. Cl.: H05K 1/16, H01L 23/64, H01L 23/66, H05K 3/00

(54) **Procédé de réalisation de motifs résonnants adaptés à la réalisation de fonctions passives RF, et circuit imprimé comportant lesdits motifs résonnants**
Herstellungsverfahren von Resonanzmotiven, die für die Erstellung von passiven RF-Funktionen geeignet sind und Leiterplatte, die diesen Resonanzmotiven umfasst
Method for producing resonating patterns suitable for the performance of passive RF functions and printed circuit comprising said resonating patterns

(30) Priorité: 12.12.2012 FR 1203378
(43) Date de publication de la demande: 18.06.2014
(73) Titulaire: Thales, 92400 Courbevoie (FR)
(72) Inventeur: Guern, Pierre, 49309 Cholet (FR)
(74) Mandataire: Marks & Clerk France

(56) Documents cités:
- EP-A1- 0 969 509
- EP-A1- 1 367 668
- US-A- 5 539 241
- US-A1- 2005 225 420
- US-A1- 2006 017 527
- US-A1- 2007 090 911
- US-B1- 6 189 201

## Description

L'objet de l'invention concerne un procédé pour réaliser un ou plusieurs motifs résonants radiofréquences adaptés à la réalisation de fonctions passives RF, ainsi qu'un circuit imprimé comportant lesdits motifs résonnants. L'invention trouve notamment son application pour réaliser des filtres accordables électriquement.

Les motifs résonnants des fonctions passives radiofréquence RF, souvent composés d'ensembles bobinages, capacités pour les fréquences inférieures à 1 GHz, peuvent être rapportés sur le circuit imprimé par collage, vissage ou soudure. Ce dernier cas est le plus fréquent, une inductance sera, par exemple, connectée par brasure sur le circuit imprimé.

Les motifs peuvent aussi être gravés, le plus souvent par attaque chimique, dans les couches conductrices du circuit imprimé. C'est la technique la plus courante pour réaliser des circuits résonnants en hyperfréquence, pour des fréquences supérieures à 1 GHz. Il est ainsi connu de réaliser par gravure chimique des fonctions passives (filtres, coupleurs, résonateurs) sur le circuit imprimé (technologie micro ruban ou en anglo-saxon microstrip) ou dans le circuit imprimé (technologie en ligne connue sous le terme anglo-saxon stripline).

Les technologies classiques utilisées pour les fonctions de filtrage « tractable » pour des fréquences inférieures à 1 GHz sont basées le plus souvent sur la mise en œuvre de selfs de forme hélicoïdale nécessitant l'emploi de composants mécaniques de grande précision entraînant des coûts importants et malgré tout une tolérance sur la valeur obtenue qui nécessite souvent une phase de réglages après fabrication, soit par adaptation de la self même, soit par le changement de valeurs des composants environnants comme les capacités.

De manière générale, les équipements radio de puissance voient leur encombrement et leur coût diminuer, pour des fiabilités requises toujours plus grandes. D'autre part, ces équipements radio sont de plus en plus constitués d'un empilement de cartes, donc de structures mécaniques plutôt planes.

La demande de brevet US 2007/090911 décrit un procédé pour réaliser un ou plusieurs motifs résonnants radio fréquence sur un circuit imprimé. Le substrat est retiré entre une spire et une spirale pour former un motif résonnant. Une partie des lignes de champ se referme à la masse à travers le substrat.

Le brevet EP 0969509 décrit la fabrication d'un circuit monolithique utilisé dans le domaine des radiofréquences dans lequel des ouvertures sont pratiquées dans la couche d'oxydation entre les spires de ruban et le substrat est gravé dans les zones d'ouverture par attaque chimique.

Il existe donc à l'heure actuelle un besoin pour des circuits imprimés réalisant différentes fonctions, incluant des fonctions de filtrage, les circuits imprimés répondant à des critères de faibles épaisseurs, de hautes performances et de faibles coûts induits et aussi de réalisation facile techniquement.

L'idée mise en œuvre selon l'invention repose notamment sur l'utilisation du circuit imprimé et les techniques de réalisation associées à la fabrication de ce dernier non pas simplement comme support de composant, mais de façon telle que le circuit lui-même réalise un certain nombre de fonctions. Le circuit n'est plus utilisé comme un simple support sur lequel on vient poser, souder ou connecter des composants entre eux.

L'invention concerne un procédé pour fabriquer un ou plusieurs motifs résonnants radio fréquence sur un circuit imprimé comprenant plusieurs couches comportant une étape de découpe par fraisage d'un ou de plusieurs motifs résonnants directement dans le circuit imprimé tout en conservant des moyens de maintien mécanique des motifs résonnants audit circuit imprimé et en combinaison au moins les étapes suivantes :
a) on réalise une gravure chimique des couches internes du circuit imprimé multicouche, puis on presse le circuit imprimé,
b) on réalise plusieurs trous nécessaires à l'obtention de trous métallisés conducteurs,
c) on réalise la métallisation des trous métallisés,
d) on réalise la gravure chimique des couches externes dudit circuit imprimé,
e) on réalise par fraisage un ou plusieurs des éléments suivants : la découpe externe du circuit imprimé, ou des contours internes, l'étape de fraisage des contours des motifs résonnants étant réalisée simultanément à l'étape b), et le procédé comporte en outre une étape de métallisation des tranches des contours des motifs résonnants réalisée simultanément à l'étape c).

Le procédé peut être utilisé pour réaliser des motifs résonnants de formes diverses, barreaux et spirales.

Le procédé décrit ci-après peut être utilisé pour réaliser des filtres planaires hautes fréquences fonctionnant dans la bande 10 MHz à 10 GHz.

L'invention concerne aussi un circuit imprimé comportant un ou plusieurs motifs résonnants obtenus par la mise en œuvre du procédé.

D'autres caractéristiques et avantages du dispositif selon l'invention apparaîtront mieux à la lecture de la description qui suit d'un exemple de réalisation donné à titre illustratif et nullement limitatif annexé des figures qui représentent :
- la figure 1, un exemple de produit obtenu par la mise en œuvre du procédé selon l'invention,
- la figure 2, un exemple de dispositif de communication intégrant un filtre obtenu par la mise en œuvre du procédé selon l'invention.

Le procédé selon l'invention repose notamment sur la réalisation, sur un circuit imprimé, de fonctions passives à air, par usinage direct du contour d'un ou plusieurs motifs résonnants dans le circuit imprimé. Les fonctions passives sont réalisées en utilisant des motifs résonnants dont les contours externes appropriés sont réalisés dans le circuit imprimé. Le motif résonant ainsi obtenu n'est pas porté par le circuit imprimé mais fait partie de celui-ci. Il est obtenu par fraisage ou découpe du circuit imprimé porteur. Il est caractérisé d'un point de vue électromagnétique par le fait que le diélectrique du motif est presque intégralement de l'air.

Le circuit imprimé est un circuit multicouche.

Selon l'invention, le motif résonnant recevra une métallisation de la ou des tranches pour améliorer sa conductivité.

Comme le circuit imprimé utilisé comporte plusieurs couches, la réalisation de motifs résonnants comportera, les étapes suivantes :
a) on réalise la gravure chimique des couches internes du circuit imprimé multicouche en utilisant un procédé connu de l'Homme du métier. Après la gravure des couches internes, on procède alors au pressage du circuit imprimé, qui consiste à coller les différentes couches ensemble. Les couches externes ne sont alors pas encore gravées,
b) on passe alors à une séquence de perçage, où on réalise les trous nécessaires à l'obtention de trous métallisés conducteurs. Les découpes internes ou externes du circuit imprimé sont faites à cette étape comme on désire métalliser les tranches de ces découpes. Les contours du ou des motifs résonants sont réalisés par fraisage à cette étape comme on désire métalliser les tranches du motif résonant. On laisse cependant des parties non fraisées comme soutiens mécaniques des motifs,
c) on réalise la métallisation des trous métallisés et par la même occasion des tranches des contours des motifs résonants,
d) on réalise la gravure chimique éventuelle des couches externes,
e) on réalise par fraisage la découpe externe du circuit imprimé, ou des contours internes.

Le motif résonnant obtenu selon l'invention peut être assez complexe et la précision de réalisation est, par exemple, de l'ordre de +/-0.1 mm. La largeur minimum des découpes obtenues par fraisage dépend de la fraise utilisée, et la fraise est choisie en fonction notamment de l'épaisseur du circuit imprimé. Elle peut descendre localement à moins d'un millimètre pour une épaisseur de circuit imprimé standard de 1,6 millimètre.

Le fraisage du circuit imprimé permet de réaliser des découpes internes afin d'obtenir les motifs souhaités par rapport à un dispositif souhaité ou la découpe du contour externe du circuit imprimé.

La métallisation des tranches ou bord des découpes est réalisée par une technique connue de l'Homme du métier, proche de la métallisation des trous métallisés. Il n'y a donc pas de surcoût important induit sur le circuit imprimé, en comparaison avec d'autres procédés d'obtention de motifs résonants comme le report de pièces « mécaniques » ou de composants.

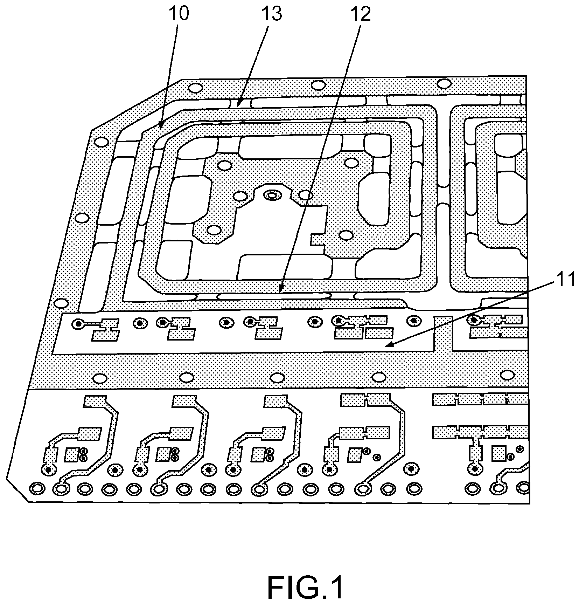

La figure 1 représente un exemple de réalisation d'un filtre obtenu par le procédé de réalisation de motifs dans le circuit imprimé. L'exemple donné concerne la réalisation d'inductances, motifs résonants d'un filtre tractable intégré dans le circuit imprimé d'une fonction radio.

Les contours du ou des motifs résonants inductifs 10 ont été directement fraisés dans le circuit imprimé 11. Les tranches des contours 12 ont été métallisées. Le motif résonnant se trouve ainsi en grande partie dans l'air retenu par des parties 13 du circuit imprimé qui n'ont pas été éliminées par le fraisage ce qui du point de vue électromagnétique assure les meilleures pertes et les plus basses capacités parasites. Ces parties ou tenons 13 du circuit restantes après le fraisage permettent le maintien mécanique du motif résonant inductif 10.

Les motifs résonants ainsi obtenus sont adaptés à la réalisation de fonctions passives RF.

L'un des objectifs de la découpe d'un ensemble de motifs dans un circuit imprimé est de réaliser par exemple un filtre qui sera utilisé dans un système de communication. Le ou les filtres obtenus par la réalisation de motifs selon l'invention peuvent être directement intégrés au circuit imprimé de la fonction « front-end radio » du moyen de communication, au niveau des différents étages amplificateurs d'émission ou de réception. La fonction principale est, dans cet exemple, le filtrage haut niveau de puissance (1 à 50W) pour permettre le fonctionnement du poste radio, en situation de proximité avec d'autres postes, dans la bande de fréquence ultra haute fréquence et très haute fréquence ou VUHF. Fonctionnellement, les filtres interviennent, en mode Réception, en tant que filtres de protection en situation de proximité du Front end, et protègent celui ci des signaux puissants issus d'émetteur en colocation proche. En mode Emission, ils filtrent le signal émis à haut niveau (1W et 50W) pour limiter le bruit large bande de l'émetteur, qui en situation de proximité va perturber les récepteurs proches.

Le procédé décrit ci-après est utilisé pour réaliser des filtres planaires hautes fréquences fonctionnant dans la bande 10 MHz à 1 GHz, voire 10 GHz.

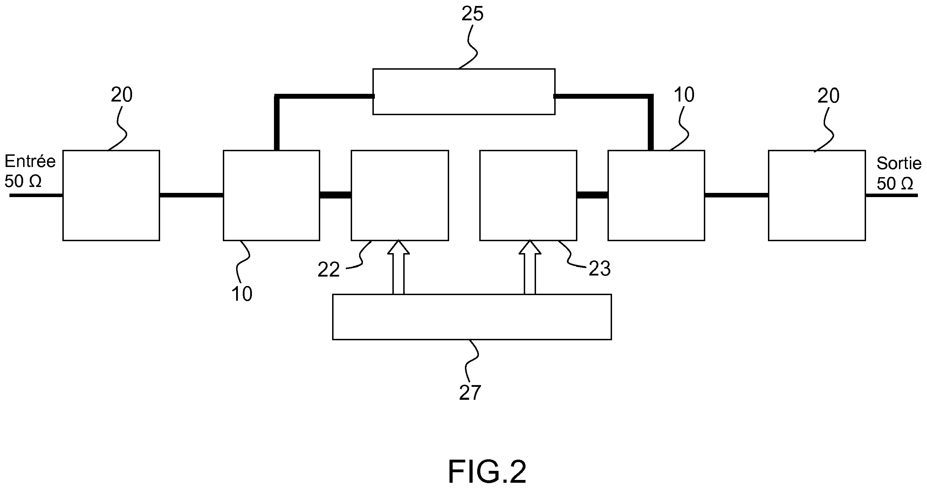

La figure 2 représente un exemple de filtre réalisé en utilisant la découpe de motifs dans un circuit imprimé comme il a été décrit précédemment. La partie principale du filtre est constituée par deux circuits oscillants parallèles composés de deux motifs résonants inductifs 10 réalisés par fraisage du circuit imprimé. Les motifs sont accordés par des boites de poids 22, 23, capacitifs dont la variation permet le centrage en fréquence du filtre. Une fonction d'adaptation 20 en impédance permet la transition entre l'interface 50 Ω et l'impédance de charge du CO (circuit oscillant) ce qui va fixer l'adaptation du filtre dans sa bande passante. Un réseau de couplage 25 contrôlé entre les deux circuits oscillants va permettre de déterminer la bande passante du filtre. Une fonction de gestion 27 du BUS, permet à partir des informations de fréquence centrale, et des signaux de commande temporels de commander les boites de poids capacitif.

Sans sortir du cadre de l'invention, il est possible de réaliser toutes formes de motifs qui seront choisis par l'utilisateur selon la fonctionnalité finale du circuit imprimé et son utilisation.

Les motifs réalisés permettant la fabrication de filtres passe bande électriquement accordables développés qui présentent les avantages suivants :
- un excellent facteur de qualité, permettant des utilisations faible bruit et /ou forte puissance,
- un très bon contrôle du couplage grâce aux précisions dimensionnelles et à la possibilité de fraiser des formes complexes, et donc une bonne maitrise de la bande passante du filtre dans la bande d'agilité du filtre,
- le circuit imprimé incluant entre autres fonctions (amplification, commutations RF) le ou les filtres accordables intègrent les motifs résonants mais aussi toute l'électronique et le système de commande nécessaire à l'utilisation de ce ou ces filtres, d'où un montage mécanique très facilité d'autant que la forme générale du filtre est plane.

Les circuits obtenus par découpe directe de motifs dans un circuit imprimé présentent notamment les avantages suivants :
- de bonnes caractéristiques radio fréquence RF dues au fait que les motifs résonnants sont quasiment dans l'air, ce qui entraîne peu de pertes diélectriques voire aucune et des capacités parasites minimales,
- la possibilité de réaliser de nombreuses formes de motif résonnant,
- une bonne précision de réalisation, de l'ordre de +/-0.1 mm,
- une très bonne reproductibilité,
- un domaine d'application assez vaste, par exemple, toutes les applications requérant des fonctions passives demandant de très faibles pertes ou de fortes puissances en RF, de quelques dizaines de MHz à plusieurs GHz,
- une configuration mécanique plane bien adaptée à la configuration actuelle des matériels radios, souvent constitués d'un empilement de cartes et modules plans,
- l'intégration de fait dans un circuit imprimé pouvant porter d'autres fonctions actives ou passives.

## Revendications

1. Procédé pour fabriquer un ou plusieurs motifs résonnants (10) radio fréquence sur un circuit imprimé (11) comprenant plusieurs couches comportant une étape de découpe par fraisage d'un ou de plusieurs motifs résonnants (10) directement dans le circuit imprimé (11) tout en conservant des moyens de maintien mécanique (13) des motifs résonnants audit circuit imprimé (11) et en combinaison au moins les étapes suivantes :
a) on réalise une gravure chimique des couches internes du circuit imprimé multicouche, puis on presse le circuit imprimé,
b) on réalise plusieurs trous nécessaires à l'obtention de trous métallisés conducteurs,
c) on réalise la métallisation des trous métallisés,
d) on réalise la gravure chimique des couches externes dudit circuit imprimé,
e) on réalise par fraisage un ou plusieurs des éléments suivants : la découpe externe du circuit imprimé, ou des contours internes, l'étape de fraisage des contours des motifs résonnants étant réalisée simultanément à l'étape b), et
le procédé comporte en outre une étape de métallisation des tranches des contours (12) des motifs résonnants réalisée simultanément à l'étape c).

2. Procédé selon la revendication 1 pour la réalisation de motifs résonnants de formes diverses, barreaux et spirales.

3. Procédé selon l'une des revendications 1 à 2 pour la réalisation de filtres planaires hautes fréquences dans la bande 10 MHz à10 GHz.

4. Circuit imprimé **caractérisé en ce qu'**il comporte un ou plusieurs motifs résonnants radiofréquence obtenus par la mise en œuvre du procédé selon l'une des revendications 1 à 3.

## Patentansprüche

1. Verfahren zur Herstellung eines oder mehrerer Funkfrequenz-Resonanzmotive (10) auf einer Leiterplatte (11), welche mehrere Schichten umfasst, umfassend einen Schritt des Ausschneidens durch Fräsen eines oder mehrerer Resonanzmotive (10) direkt in der Leiterplatte (11), wobei mechanische Haltemittel (13) der Resonanzmotive an der Leiterplatte (11) beibehalten werden, und in Kombination mindestens folgende Schritte:
a) chemisches Gravieren der inneren Schichten der mehrschichtigen Leiterplatte, und anschließend Pressen der Leiterplatte,
b) Herstellen von mehreren Löchern, notwendig sind,um metallisierte, leitfähige Löcher zu erhalten,
c) Metallisieren der metallisierten Löcher,
d) chemisches Gravieren der äußeren Schichten der Leiterplatte,
e) Herstellen eines oder mehrerer der folgenden Elemente durch Fräsen: äußeres Ausschneiden der Leiterplatte, oder der inneren Konturen, wobei der Schritt des Fräsens der Konturen der Resonanzmuster gleichzeitig mit Schritt b) ausgeführt wird, und das Verfahren ferner einen Schritt des Metallisierens der Kanten der Konturen (12) der Resonanzmotive umfasst, welcher gleichzeitig mit Schritt c) ausgeführt wird.

2. Verfahren nach Anspruch 1 zur Herstellung von Resonanzmotiven diverser Formen, Stäbe und Spiralen.

3. Verfahren nach einem der Ansprüche 1 bis 2 zur Herstellung von planaren Hochfrequenzfiltern im Band 10 MHz bis 10 GHz.

4. Leiterplatte, **dadurch gekennzeichnet, dass** sie ein oder mehrere Funkfrequenz-Resonanzmotive umfasst, welche durch die Umsetzung des Verfahrens nach einem der Ansprüche 1 bis 3 erzielt wurden.

## Claims

1. A method for producing one or more radio-frequency resonant patterns (10) on a printed circuit (11) comprising multiple layers comprising a step of milling cutting one or more resonant patterns (10) directly into the printed circuit (11) whilst preserving means (13) for mechanically securing the resonant patterns to said printed circuit (11), and in combination at least the following steps:
a) chemically etching the internal layers of the multilayer printed circuit, after which the printed circuit is pressed,
b) producing multiple holes necessary for obtaining conductive metallized vias,
c) metallizing the metalized vias,
d) chemically etching the external layers of said printed circuit,
e) one or more of the following elements are produced by milling: external cutting of the printed circuit, or of the internal contours, the step of milling the contours of the resonant patterns being carried out simultaneously with step b), and the method further comprising a step of metallizing the edges of the contours (12) of the resonant patterns, being carried out simultaneously with step c).

2. The method according to claim 1 for the production of resonant patterns of diverse shapes, bars and spirals.

3. The method according to one of claims 1 to 2 for the production of planar highfrequency filters operating in the band from 10 MHz to 10 GHz.

4. The printed circuit **characterized in that** it comprises one or more radio-frequency resonant patterns by carrying out the method according to one of claims 1 to 3.
